# EUROPEAN PATENT SPECIFICATION

(11) **EP 4 050 976 B1**
(45) Date of publication and mention of the grant of the patent: **03.09.2025**
(21) Application number: 20878371.2
(22) Date of filing: 07.07.2020
(51) Int. Cl.: F24F 1/22

(54) **INTEGRATED AIR SOURCE HEAT PUMP**
WÄRMEPUMPE MIT INTEGRIERTER LUFTQUELLE
POMPE À CHALEUR À SOURCE D'AIR INTÉGRÉE

(30) Priority: 22.10.2019 CN 201911007271
(43) Date of publication of application: 31.08.2022
(73) Proprietor: Qingdao Hisense Hitachi Air-Conditioning Systems Co., Ltd., Qingdao, Shandong (CN)
(72) Inventor: ZHAO, Xijiang, Qingdao, Shandong (CN); GONG, Zhenhua, Qingdao, Shandong (CN); ZHANG, Dongli, Qingdao, Shandong (CN); YANG, Xiaoxia, Qingdao, Shandong (CN)
(74) Representative: Casalonga
(86) International application number: PCT/CN2020/100560
(87) International publication number: WO 2021/077802

(56) References cited:
- EP-A1- 2 896 529
- CN-A- 106 839 162
- CN-A- 106 839 164
- CN-A- 106 931 543
- CN-A- 106 969 430
- CN-A- 107 327 969
- CN-A- 107 366 986
- CN-A- 107 514 706
- CN-A- 109 442 596
- CN-U- 206 739 467
- CN-U- 206 739 468
- CN-U- 206 739 469
- KR-A- 20180 065 725
- US-A1- 2007 006 610
- US-B2- 8 763 416

## Description

This application claims priority to Chinese Patent Application No. 201911007271.9, filed with the Chinese Patent Office on October 22, 2019, titled "INTEGRATED AIR SOURCE HEAT PUMP".

### TECHNICAL FIELD

The present invention relates to the field of heating and air conditioning apparatus technologies, and in particular, to an integrated air source heat pump.

### BACKGROUND

Air source heat pumps are either split or integrated. A split air source heat pump, similar to an air conditioner, also includes an indoor unit and an outdoor unit. Components such as a heat exchanger and a water pump are disposed in the indoor unit, and the indoor unit occupies some indoor living space, which affects the user's living experience. In order to solve a problem that the indoor unit occupies the indoor living space, an integrated air source heat pump emerges as the times require, and the integrated air source heat pump integrates the heat exchanger, the water pump and other components in the outdoor unit.

In the modern society where an inch of land is an inch of gold, high requirements are put forward for a maximum utilization of space, a small unit having a large capacity has become a goal pursued by people, and how to achieve a miniaturized design of the integrated air source heat pump is a hot research direction in the industry. With the development trend of miniaturization of the air source heat pump, a size of an electrical box which is an important component of the air source heat pump must be reduced as well, which requires a more compact layout of electrical components in an interior of the electrical box. In addition, while the electrical box is compactly designed, how to achieve efficient heat dissipation of the electrical box is also a technical problem to be solved.

CN107366986A discloses a baffle structure, an electronic control box with the baffle structure, an air conditioner outdoor unit with the electronic control box, and an air conditioner with the air conditioner outdoor unit. The baffle structure is applied to the electronic control box. A containing cavity is formed in the electronic control box and comprises at least one air inlet and at least one air outlet. The electronic control box further comprises a control assembly contained in the containing cavity. The baffle structure comprises an installation part arranged in the electronic control box, and a water blocking plate arranged at one end of the installation part in a protruding manner. The water blocking plate is located between the air outlets and the control assembly. At least one cooling hole is formed in the water blocking plate. The air inlets, the cooling holes and the air outlets communicate to form a gas flow channel.

CN107514706A discloses an electric control module, an outdoor unit of an air conditioner and the air conditioner. The electric control module is arranged in a shell of the outdoor unit of the air conditioner, and comprises a circuit board, a mounting box, a support box body and a cover plate, wherein an accommodating tank is formed in the mounting box; the circuit board is partially accommodated in the accommodating tank; an accommodating cavity is formed in the support box body, and is provided with an opening; the circuit board and the mounting box are accommodated in the accommodating cavity through the opening; the support box body is provided with at least one exhaust port and at least one intake port communicating with the accommodating cavity; the cover plate covers the opening to close the accommodating cavity; and one side, deviated from the circuit board, of the mounting box butts against the cover plate.

CN106839162A discloses an outdoor machine and an air conditioner. The outdoor machine comprises an outdoor shell, a heat exchanger, a partition plate and an electric control device, wherein the outdoor shell is provided with an air inlet and an air outlet; the heat exchanger is located between the air inlet and the air outlet; an accommodating space is defined between the heat exchanger and one side, close to the air outlet, of the outdoor shell; the partition plate is arranged in the accommodating space to partition the accommodating space into a compressor cavity and a fan cavity; the electric control device comprises an electric control box, a circuit board, a heating element and a radiator; the electric control box is located in the compressor cavity and roughly vertically arranged on the side wall of the partition plate; one side, toward the partition plate, of the electric control box is open; the circuit board is roughly vertically arranged in the electric control box and one side, with the heating element, of the circuit board is arranged opposite to the parturition plate through the open side of the electric control box; the radiator is in contact with the heating element; and a cooling fin of the radiator sequentially passes through the side wall of the electric control box and the partition plate to extend into the fan cavity.

### SUMMARY

The present disclosure provides an integrated air source heat pump , and the integrated air source heat pump is defined by the appended claim 1.

### BRIEF DESCRIPTION OF THE DRAWINGS

In order to describe technical solutions in embodiments of the present disclosure or in the prior art more clearly, accompanying drawings to be used in the embodiments or the prior art will be briefly introduced below. However, the accompanying drawings to be described below are merely some embodiments of the present disclosure, and a person of ordinary skill in the art may obtain other drawings according to these drawings without paying any creative effort.
FIG. 1 is an exploded view showing a structure of an integrated air source heat pump, in accordance with some embodiments of the present disclosure;
FIG. 2 is a diagram showing a structure of an integrated air source heat pump (with a housing omitted), in accordance with some embodiments of the present disclosure;
FIG. 3 is a diagram showing a structure of an integrated air source heat pump (with a housing omitted) in another perspective, in accordance with some embodiments of the present disclosure;
FIG. 4 is a front view of an integrated air source heat pump (with a housing and components in a second installation space omitted), in accordance with some embodiments of the present disclosure;
FIG. 5 is a diagram showing a structure of a whole machine of an integrated air source heat pump, in accordance with some embodiments of the present disclosure;
FIG. 6 is a diagram showing a structure of an electrical box, in accordance with some embodiments of the present disclosure;
FIG. 7 is an exploded view showing a structure of an electrical box, in accordance with some embodiments of the present disclosure;
FIG. 8 is a diagram showing a structure of a first bracket of an electrical box, in accordance with some embodiments of the present disclosure; and
FIG. 9 is a diagram showing a structure of a radiator of an electrical box, in accordance with some embodiments of the present disclosure.

100, housing;
110, first installation space;
120, second installation space;
130, bottom plate;
140, top plate;
150, right side wall;
151, air inlet;
160, fan panel;
161, air outlet;
170, maintenance plate;
190, accommodating space;
200, electrical box;
210, box body;
211, bottom side plate;
212, left side plate;
213, right side plate;
214, rear side plate;
2141, first rear side plate portion;
2142, second rear side plate portion;
2143, third rear side plate portion;
215, front side plate;
220, box cover;
221, turn-up plate;
231, driving board;
232, main control board;
233, inductance coil;
234, debugging board;
24, bracket;
241, first bracket;
242, second bracket;
243, support portion;
244, claw;
251, first air inlet hole;
252, second air inlet hole;
253, air outlet hole;
254, air outlet gap;
261, wiring hole;
262, wire binding bracket;
263, opening;
270, radiator;
271, first heat dissipation fin group;
272, second heat dissipation fin group;
273, gap;
274, ventilation passage;
275, slope portion;
300, partition plate;
310, partition plate body;
320, partition plate flange;
400, support plate;
500, fan bracket;
510, fan bracket vertical portion;
520, fan bracket lateral portion;
600, support beam;
710, first heat exchanger;
720, fan;
730, second heat exchanger;
740, compressor;
750, water pump;
760, water pump bracket;
770, refrigeration system container;
X1, high heat region;
X2, medium heat region;
X3, low heat region.

### DETAILED DESCRIPTION

In order to make the purpose, technical solutions and advantages of embodiments of the present disclosure clear, technical solutions in the embodiments of the present disclosure will be described clearly and completely below with reference to the accompanying drawings in the embodiments of the present disclosure. However, the described embodiments are merely some but not all embodiments of the present disclosure. All other embodiments obtained by a person of ordinary skill in the art on the basis of the embodiments of the present disclosure and falling within the scope of the claims shall be included in the protection scope of the present disclosure.

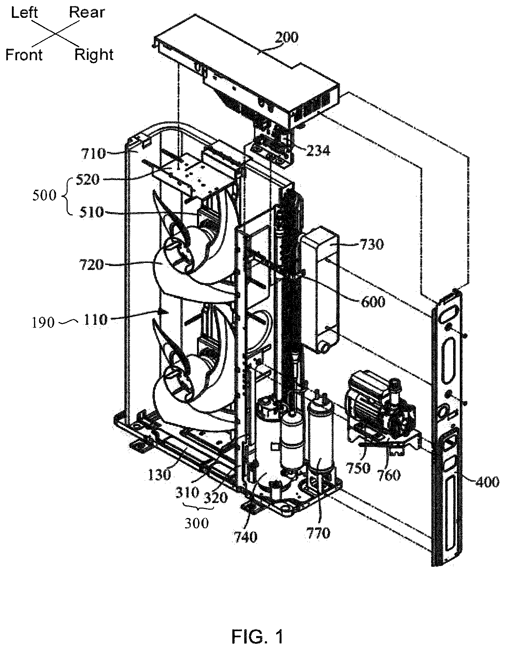

The present disclosure provides an integrated air source heat pump. As shown in FIGS. 1 to 5, the integrated air source heat pump includes a housing 100. The housing 100 forms an accommodating space 190.

An electrical box 200 is disposed at a top of the accommodating space 190. The electrical box 200 is disposed at the top, so that the accommodating space 190 may be fully utilized, which helps to reduce a volume of a whole machine and achieve a miniaturization design of the whole machine.

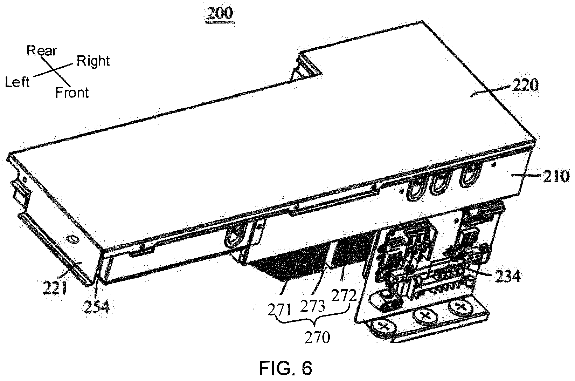

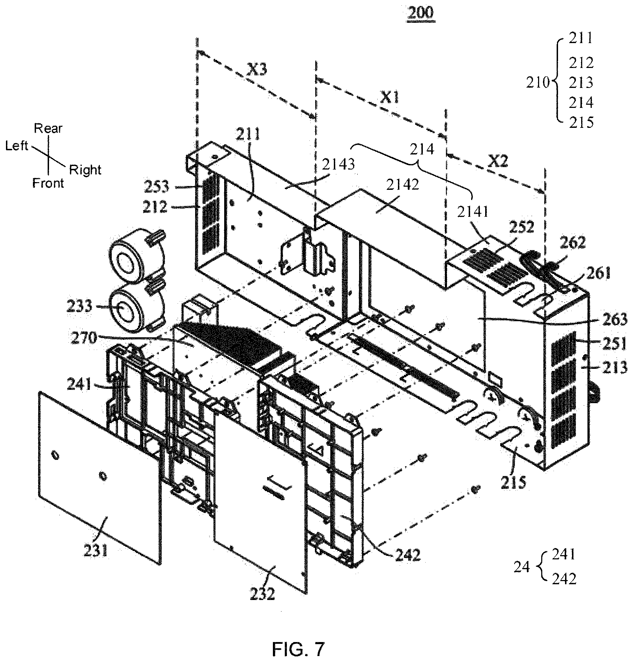

FIG. 6 is a diagram showing a structure of the electrical box, in accordance with some embodiments of the present disclosure; and FIG. 7 is an exploded view showing a structure of the electrical box, in accordance with some embodiments of the present disclosure. Referring to FIGS. 6 and 7, the electrical box 200 includes a main body of the electrical box. The main body of the electrical box includes a box body 210 and a box cover 220. The box body 210 and the box cover 220 are enclosed to form an inner space of the electrical box for installing components.

The box body 210 includes a bottom side plate 211, and a left side plate 212, a right side plate 213, a front side plate 215 and a rear side plate 214 that are disposed around the bottom side plate 211 and extend toward a direction of the box cover 220.

A bracket 24 is fixedly connected to the bottom side plate 211 by means of screws or the like. The bracket 24 includes a first bracket 241 and a second bracket 242. The first bracket 241 and the second bracket 242 provide support for installations of other components.

A driving board 231 is fixedly connected to a side of the first bracket 241 facing the box cover 220, and a radiator 270 is fixedly connected to a side of the first bracket 241 facing the bottom side plate 211 by means of screws or the like.

A main control board 232 is fixedly connected to a side of the second bracket 242 facing the box cover 220, and the main control board 232 is connected to a debugging board 234.

The driving board 231 generally integrates heat-generating components such as a central processing unit (CPU), a compressor driving chip, a fan driving chip and a silicon bridge. The main control board 232 generally integrates heat-generating components such as an electrolytic capacitor and a switching power chip. An operating current of the driving board 231 is high. An amount of heat generated by the driving board 231 is higher than an amount of heat generated by the main control board 232.

The first bracket 241 is located in a middle region of the inner space of the electrical box 200. The second bracket 242 is located in a right region, of the inner space of the electrical box 200, proximate to the right side plate 213. An opening 263 for the radiator 270 to protrude is disposed on the bottom side plate 211, and the radiator 270 protrudes from the opening 263.

Thus, in the inner space of the electrical box 200, the middle region in which the driving board 231 is disposed is a high heat region (marked as X1), and the right region in which the main control board 232 is disposed is a medium heat region (marked as X2).

The bottom side plate 211 is further provided with an inductance coil 233, which is located in a left region, of the inner space of the electrical box 200, proximate to the left side plate 212, and the left region is a low heat region (marked as X3).

A plurality of first air inlet holes 251 are disposed on the right side plate 213, a plurality of second air inlet holes 252 are disposed on the rear side plate 214, and a plurality of air outlet holes 253 are disposed on the left side plate 212.

The air enters inside the electrical box 200 from the first air inlet holes 251 and the second air inlet holes 252, sequentially flows through the medium heat region X2, the high heat region X1 and the low heat region X3, and then flows out from the air outlet holes 253, so that ventilation and heat dissipation of electrical components such as the main control board 232, the driving board 231 and the inductance coil 233 are achieved, energy consumption is low, and a heat dissipation effect is good.

Meanwhile, the radiator 270 performs synchronous heat dissipation on the driving board 231 with a high temperature, that is, double heat dissipation is performed on the driving board 231 by using the radiator 270 and natural wind, which may effectively and rapidly reduce a temperature of the high heat region X1.

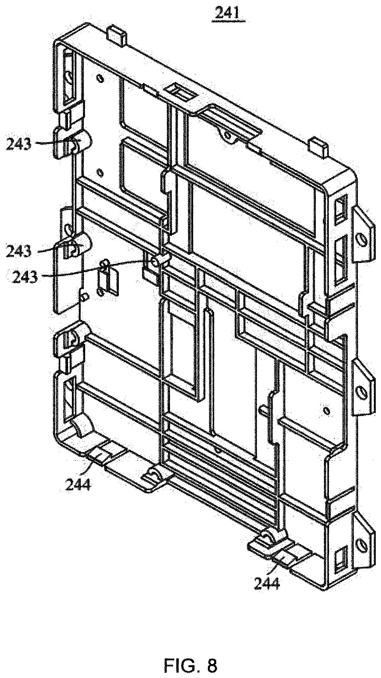

A diagram showing a structure of the first bracket 241 may refer to FIG. 8. A plurality of support portions 243 are disposed on side plates around the first bracket 241 and in a middle region of the first bracket 241, and are used for abutting against the driving board 231, which enhances strength of the first bracket 241, and supports the driving board 231 to avoid a deformation of the driving board 231.

A plurality of claws 244 are also disposed on the side plates around the first bracket 241, and the plurality of claws 244 are used for being snapped with the driving board 231 to further enhance connection reliability of the driving board 231 and prevent the driving board 231 from tilting.

Similarly, the plurality of support portions 243 and the plurality of claws 244 are also disposed on the second bracket 242, which are used to enhance connection reliability of the main control board 232 and reduce a deformation of the main control board 232.

Apertures of the first air inlet holes 251, the second air inlet holes 252 and the air outlet holes 253 are preferably less than 2 mm, so that in a case where the ventilation is ensured, foreign matters such as insects may be prevented from entering inside the electrical box 200 to cause an accidental short circuit.

As shown in FIG. 6, the box cover 220 has a turn-up plate 221 bent downwards, and there is an air outlet gap 254 between the turn-up plate 221 and the air outlet holes 253. In a case where the ventilation is ensured, the turn-up plate 221 may prevent rainwater from entering inside the electrical box 200 to cause the short circuit, and improve reliability of the electrical box 200.

As shown in FIG. 7, a plurality of wiring holes 261 are disposed on the front side plate 215 and the rear side plate 214, and are used for wiring of internal electrical components. Wire binding brackets 262 are also disposed at positions proximate to the wiring holes 261. The wire binding brackets 262 are used for wire binding, so that the wiring is reliable, neat and orderly.

The electrical box 200 is applied to the integrated air source heat pump. In order to further enhance the heat dissipation effect of the electrical box 200, improve compactness of an internal structure of the air source heat pump, and reduce the volume of the whole machine, in the present disclosure, innovative improvements are made on an arrangement position of the electrical box 200, an assembled structure between the electrical box 200 and the air source heat pump, and an internal structure layout of the air source heat pump.

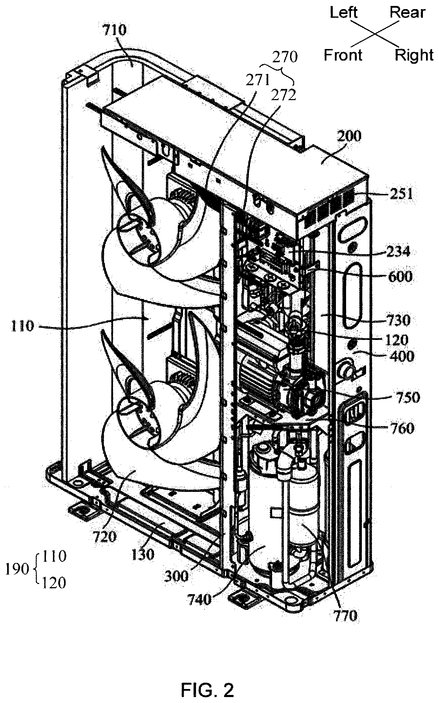

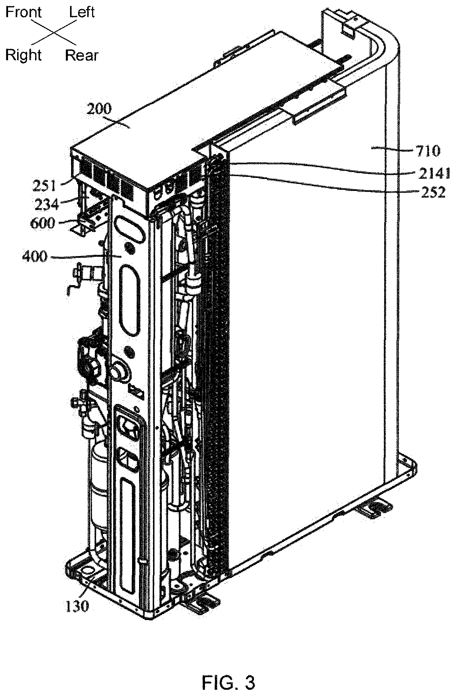

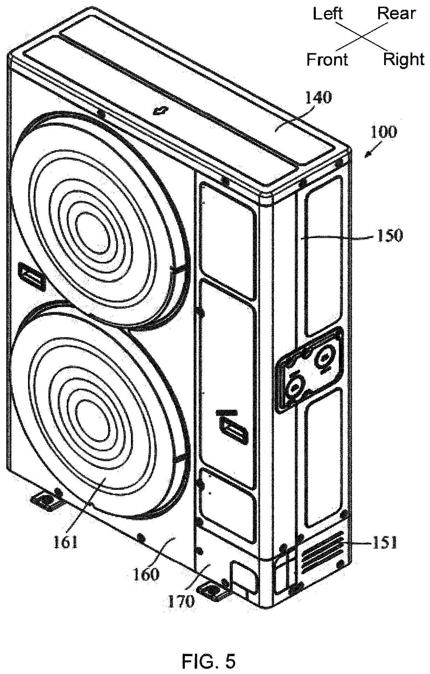

For the diagrams showing a structure of the integrated air source heat pump disclosed by the embodiments, reference may be made to FIGS. 1 to 5. FIG. 5 is a diagram showing a structure of the whole machine of the integrated air source heat pump. FIG. 1 is an exploded view showing a structure of the integrated air source heat pump. FIGS. 2 and 3 are diagrams showing layout structures of the internal components of the integrated air source heat pump, and in FIGS. 1 to 3, the housing 100 is omitted for convenience of showing the internal structure.

Referring to FIGS. 1 and 5, the integrated air source heat pump includes the housing 100. The housing 100 includes a bottom plate 130, a top plate 140, a left side wall, a right side wall 150, and a rear plate, and a front portion of the housing 100 is composed of a fan panel 160 and a maintenance plate 170.

As shown in FIG. 5, the fan panel 160 is disposed on a left side, and air outlets 161 are disposed on the fan panel 160 for air to go out. The maintenance plate 170 is disposed on a right side. In a case where the components inside the housing 100 need to be repaired, the maintenance plate 170 is detached.

Referring to FIGS. 1 to 3, a partition plate 300 and a support plate 400 extending along a vertical direction that are arranged separately are disposed on the bottom plate 130. The partition plate 300 divides the inner space of the housing 100 into a first installation space 110 and a second installation space 120 disposed on a left side and a right side. The support plate 400 is located in the second installation space 120 and is directly opposite to the partition plate 300.

A first heat exchanger 710 is disposed in the first installation space 110, a fan bracket 500 is disposed on the first heat exchanger 710, and fans 720 are disposed on the fan bracket 500.

A compressor 740, a refrigeration system container 770, a water pump 750, a second heat exchanger 730, wiring and tubes or the like are disposed in the second installation space 120.

The electrical box 200 is disposed at tops of the first installation space 110 and the second installation space 120. A left end of the electrical box 200 is fixedly connected to the fan bracket 500, a right end of the electrical box 200 is fixedly connected to the support plate 400, and the bottom side plate 211 of the electrical box 200 abuts against an upper end of the partition plate 300.

Both the radiator 270 and the debugging board 234 are located in the inner space of the housing 100.

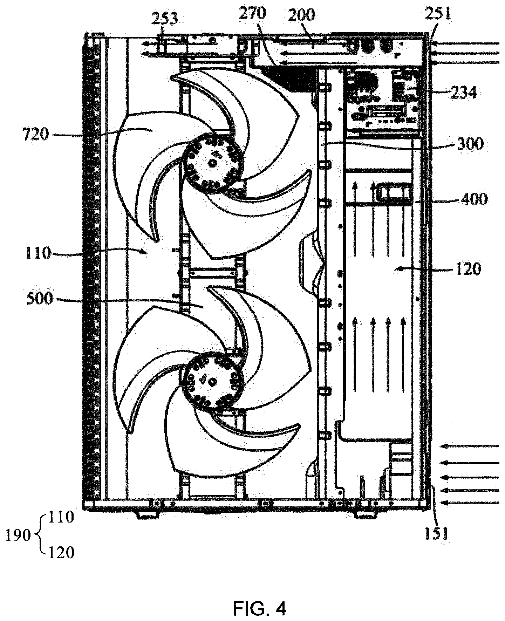

FIG. 4 is a front view of the integrated air source heat pump (with the housing and components in the second installation space omitted), in accordance with some embodiments of the present disclosure. FIG. 4 shows a flow direction of air inside the air source heat pump when the fans 720 are operating. A part of outside air flows inside the electrical box 200 from the first air inlet holes 251 and the second air inlet holes 252 of the electrical box 200 due to wind pressure, and then flows out from the air outlet holes 253 of the electrical box 200.

Another part of the outside air enters the second installation space 120 from air inlets 151 on the housing 100 and flows upwards due to the wind pressure, then enters inside the electrical box 200 through the opening 263 on the bottom side plate 211 of the electrical box 200, and finally flows out from the air outlet holes 253. Air flows into the electrical box 200 from a rear side, a right side and a bottom side of the electrical box 200, and flows from the right end of the electrical box 200 to the left end of the electrical box 200, so as to dissipate the heat of the electrical components inside the electrical box 200, the heat dissipation effect is good and there is no space that cannot be dissipated heat.

In the present disclosure, the electrical box 200 is disposed at the top, so that the inner space of the housing 100 is fully utilized, which helps to reduce the volume of the whole machine and achieve the miniaturization design of the whole machine.

In a possible embodiment, as shown in FIG. 1, the first heat exchanger 710 is an L-shaped fin heat exchanger. The first heat exchanger 710 is fixedly connected to the bottom plate 130. A long side portion of the first heat exchanger 710 is located on a rear side of the first installation space 110, and a short side portion of the first heat exchanger 710 is located on a left side of the first installation space 110.

The fan bracket 500 extends along a height direction of the first heat exchanger 710. The fans 720 are located in a space enclosed by the L-shaped first heat exchanger 710 to improve a heat exchange efficiency. A side edge of the partition plate 300 proximate to the first heat exchanger 710 is fixedly connected to the first heat exchanger 710.

As shown in FIG. 1, the fan bracket 500 has a fan bracket vertical portion 510 and a fan bracket lateral portion 520. The fan bracket vertical portion 510 is fixedly connected to the first heat exchanger 710, and the fan bracket lateral portion 520 is located above the fans 720.

The fans 720 are fixedly connected to the fan bracket vertical portion 510, and the bottom side plate 211 of the electrical box 200 is fixedly connected to the fan bracket lateral portion 520 to fix the left end of the electrical box 200.

In some embodiments of the present disclosure, as shown in FIG. 1, the partition plate 300 has an L-shaped structure. The partition plate 300 includes a partition plate body 310 and a partition plate flange 320. The partition plate body 310 is fixedly connected to the first heat exchanger 710, and the partition plate flange 320 is connected to a front side wall of the housing 100.

The fan panel 160 located on the front side wall of the housing 100 is fixedly connected to the partition plate flange 320, and the maintenance plate 170 is detachably and fixedly connected to the partition plate flange 320.

Compared with a common C-shaped partition plate in the prior art, a length of the L-shaped first heat exchanger 710 is shortened, and the L-shaped first heat exchanger 710 is fixedly connected to the L-shaped partition plate 300, which helps to reduce an internal occupied space of the partition plate 300, and further helps to reduce the volume of the whole machine.

As shown in FIG. 2, a layout of the components in the second installation space 120 is as follows. The compressor 740 and the refrigeration system container 770 are fixedly connected to the bottom plate 130, the second heat exchanger 730 is fixedly connected to the support plate 400. The water pump 750 is located above the compressor 740 and the refrigeration system container 770, and the water pump 750 is fixedly disposed on a water pump bracket 760. An end of the water pump bracket 760 is fixedly connected to the partition plate 300, and another end of the water pump bracket 760 is fixedly connected to the support plate 400. The components are compact in layout and occupy small space.

The second heat exchanger 730 may be a water-fluorine plate heat exchanger, a shell-and-tube heat exchanger, a double pipe heat exchanger, or the like. The refrigeration system container 770 may be a liquid storage tank or the like.

As shown in FIGS. 1 and 2, a support beam 600 is also disposed in the second installation space 120. An end of the support beam 600 is fixedly connected to the partition plate 300, and another end of the support beam 600 is fixedly connected to the second heat exchanger 730.

The debugging board 234 is fixedly connected to the support beam 600, so as to achieve a fixed installation of the debugging board 234 and prevent the debugging board 234 from shaking.

The support plate 400, preferably, has an L-shaped structure. A lower end of the support plate 400 is fixedly installed on a right side edge and a rear side edge of the bottom plate 130, that is, the lower end of the support plate 400 is fixedly installed at a right rear corner of the bottom plate 130. Meanwhile, an upper end of the support plate 400 is fixedly connected to the right side plate 213 and the rear side plate 214 of the electrical box 200, so as to fix the right end of the electrical box 200.

So far, through a fixed connection between the left end of the electrical box 200 and the fan bracket lateral portion 520, a fixed connection between the right end of the electrical box 200 and the support plate 400, an abutting relationship between the bottom side plate 211 and the partition plate 300, and a fixed connection between the debugging board 234 and the support beam 600, a fixed installation of the electrical box 200 is achieved, so that the electrical box 200 is reliably and stably installed at a top of the air source heat pump, an existing structure of the air source heat pump is fully used for installation support, and small space is occupied.

The debugging board 234 is preferably located in the second installation space 120. During maintenance, the debugging board 234 may be repaired by detaching the maintenance plate 170 at the front portion, which is easy to operate.

A plurality of through holes (not shown) for ventilation are disposed both on the partition plate 300 and the support plate 400, so as to improve fluidity of air in the first installation space 110 and the second installation space 120, which facilitates the heat dissipation.

In a case where the bottom side plate 211 of the electrical box 200 abuts against the partition plate 300, in order to enhance an abutting firmness between the bottom side plate 211 of the electrical box 200 and the partition plate 300, and to enhance the heat dissipation effect of the radiator 270, a structure of the radiator 270 is also improved in the present disclosure.

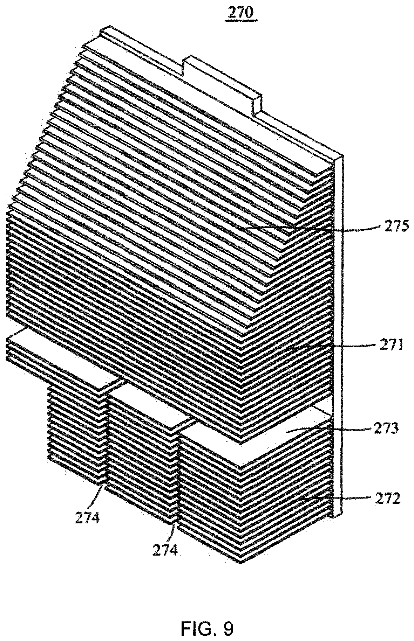

For a diagram showing the structure of the radiator 270, reference may be made to FIG. 9. The radiator 270 includes a first heat dissipation fin group 271 and a second heat dissipation fin group 272 with a gap 273 therebetween.

The partition plate 300 is inserted in the gap 273 between the first heat dissipation fin group 271 and the second heat dissipation fin group 272, and abuts against the bottom side plate 211. The first heat dissipation fin group 271 is located in the first installation space 110, and the second heat dissipation fin group 272 is located in the second installation space 120.

The gap 273 between the first heat dissipation fin group 271 and the second heat dissipation fin group 272 has a limiting effect on the upper end of the partition plate 300, so as to prevent the upper end of the partition plate 300 from tilting or shaking.

Meanwhile, the radiator 270 designed in this way can make full use of top spaces of the first installation space 110 and the second installation space 120, so that the radiator 270 is made as large as possible to improve the heat dissipation efficiency.

In some embodiments of the present disclosure, the first heat dissipation fin group 271 is proximate to the left side plate 212, there is a slope portion 275 on a side of the first heat dissipation fin group 271 proximate to the fans 720. The slope portion 275 is used to provide a space for the fan bracket lateral portion 520, so as to facilitate the installation of the electrical box 200.

Meanwhile, the first heat dissipation fin group 271 is proximate to the fans 720, which also facilitates airflow at the fans 720 to dissipate heat from the first heat dissipation fin group 271, thereby improving the heat dissipation efficiency.

In some embodiments of the present disclosure, the second heat dissipation fin group 272 is proximate to the right side plate 213. At least one ventilation passage 274 for ventilation is disposed on the second heat dissipation fin group 272. In this embodiment, there are two ventilation passages 274. The ventilation passages 274 are perpendicular to fins of the second heat dissipation fin group 272.

Airflow flowing upwards from a bottom of the second installation space 120 will flow through an interior of the second heat dissipation fin group 272 through the ventilation passages 274, which helps to improve the heat dissipation efficiency of the second heat dissipation fin group 272.

FIG. 7 is an exploded view showing a structure of the electrical box, in accordance with some embodiments of the present disclosure. In a possible embodiment, referring to FIG. 7, the rear side plate 214 of the electrical box 200 includes a first rear side plate portion 2141, a second rear side plate portion 2142 and a third rear side plate portion 2143 that are sequentially connected to form a stepped structure. A distance between the first rear side plate portion 2141 and the front side plate 215 is greater than a distance between the third rear side plate portion 2143 and the front side plate 215. The second air inlets holes 252 are disposed on the first rear side plate portion 2141.

The rear side plate 214 is designed into the stepped structure, which is mainly to enable the electrical box 200 to be well matched and be connected with the internal components such as the first heat exchanger 710 and to reduce the occupied space.

After the electrical box 200 is installed in place, the first rear side plate portion 2141 is located on a right side of the first heat exchanger 710, so as to make full use of the top space of the second installation space 120. The stepped structure between the second rear side plate portion 2142 and the third rear side plate portion 2143 is used to provide a space for the fan bracket lateral portion 520, so that the rear side plate 214 can abut against the first heat exchanger 710 to reduce the occupied space.

## Claims

1. An integrated air source heat pump, comprising:
a housing (100), the housing (100) being used to form an accommodating space (190); and
an electrical box (200), the electrical box (200) being disposed in the accommodating space (190);
**characterized in that**, the electrical box (200) includes:
a main body of the electrical box (200), an interior of the main body of the electrical box (200) forming an inner space of the electrical box (200);
a bracket (24), the bracket (24) being used as an installation carrier for components, and the bracket (24) being disposed in the inner space of the electrical box (200);
a driving board (231), the driving board (231) being disposed on the bracket (24), the driving board (231) being located at a middle position of the inner space of the electrical box (200);
a radiator (270), the radiator (270) being used to dissipate heat from the inner space of the electrical box (200), the radiator (270) being disposed on the bracket (24), and the radiator (270) and the driving board (231) being disposed on two opposite sides of the bracket (24), respectively;
a plurality of first air inlet holes (251), the first air inlet holes (251) being disposed on a right side of the main body of the electrical box (200);
a plurality of second air inlet holes (252), the second air inlet holes (252) being disposed on a rear side of the main body of the electrical box (200);
a plurality of air outlet holes (253), the air outlet holes (253) being disposed on a left side of the main body of the electrical box (200);
a main control board (232), the main control board (232) being disposed on the bracket (24), and the main control board (232) being located at a right position of the inner space of the electrical box (200);
an inductance coil (233), the inductance coil (233) being located at a left position of the inner space of the electrical box (200);
a debugging board (234), the debugging board (234) being disposed on the main control board (232);
the main body of the electrical box (200) includes a box body (210) and a box cover (220), and the inner space of the electrical box (200) is formed between the box body (210) and the box cover (220); and
the box cover (220) has a turn-up plate (221) bent downwards, and an air outlet gap (254) is disposed between the turn-up plate (221) and the air outlet holes (253).

2. The integrated air source heat pump according to claim 1, **characterized in that**,
the box body (210) includes a bottom side plate (211), and a left side plate (212), a right side plate (213), a front side plate (215) and a rear side plate (214) that are disposed around the bottom side plate (211);
both the bracket (24) and the inductance coil (233) are disposed on the bottom side plate (211);
an opening (263) is disposed on the bottom side plate (211), and the radiator (270) protrudes from the opening (263); and
the first air inlet holes (251) are disposed on the right side plate (213), the second air inlet holes (252) are disposed on the rear side plate (214), and the air outlet holes (253) are disposed on the left side plate (212).

3. The integrated air source heat pump according to claim 2, **characterized in that**,
the bracket (24) includes a first bracket (241) and a second bracket (242), the first bracket (241) is located at a middle region of the inner space of the electrical box (200), and the second bracket (242) is proximate to the right side plate (213);
the driving board (231) is disposed on a side of the first bracket (241) facing the box cover (220), and the radiator (270) is disposed on a side of the first bracket (241) facing the bottom side plate (211); and
the main control board (232) is disposed on a side of the second bracket (242) facing the box cover (220).

4. The integrated air source heat pump according to claim 3, **characterized in that**,
the radiator (270) includes a first heat dissipation fin group (271) and a second heat dissipation fin group (272) with a gap (273) disposed therebetween;
the first heat dissipation fin group (271) is proximate to the left side plate (212), the second heat dissipation fin group (272) is proximate to the right side plate (213), at least one ventilation passage (274) for ventilation is disposed on the second heat dissipation fin group (272), and the ventilation passage (274) is perpendicular to fins of the second heat dissipation fin group (272);
a slope portion (275) is formed on a side of the first heat dissipation fin group (271) proximate to the left side plate (212).

5. The integrated air source heat pump according to claim 4, **characterized in that**,
a plurality of support portions (243) are disposed both on the first bracket (241) and the second bracket (242), and the support portions (243) are used for abutting against the driving board (231) and the main control board (232); and
a plurality of claws (244) are disposed both on the first bracket (241) and the second bracket (242), and the claws (244) are used for being snapped with the driving board (231) and the main control board (232).

6. The integrated air source heat pump according to claim 4, **characterized in that**,
the rear side plate (214) includes a first rear side plate portion (2141), a second rear side plate portion (2142) and a third rear side plate portion (2143) which are sequentially connected to form a stepped structure, and a distance between the first rear side plate portion (2141) and the front side plate (215) is greater than a distance between the third rear side plate portion (2143) and the front side plate (215); and the second air inlet holes (252) are disposed on the first rear side plate portion (2141).

7. The integrated air source heat pump according to any of claims 4 to 6, **characterized in that**,
the electrical box (200) is located at a top of the accommodating space (190).

8. The integrated air source heat pump according to claim 7, **characterized in that**,
the housing (100) has a bottom plate (130), a partition plate (300) and a support plate (400) that are arranged separately are disposed on the bottom plate (130) along a vertical direction, the partition plate (300) divides the accommodating space (190) into a first installation space (110) and a second installation space (120) that are disposed on a left side and a right side, and the support plate (400) is located in the second installation space (120) and is directly opposite to the partition plate (300);
a first heat exchanger (710) is disposed in the first installation space (110), a fan bracket (500) is disposed on the first heat exchanger (710), and a fan (720) is disposed on the fan bracket (500);
a compressor (740), a refrigeration system container (770), a water pump (750) and a second heat exchanger (730) are disposed in the second installation space (120); and
the electrical box (200) is disposed at tops of the first installation space (110) and the second installation space (120), a left end of the electrical box (200) is connected to the fan bracket (500), and a right end of the electrical box (200) is connected to the support plate (400); the partition plate (300) is inserted in the gap (273) between the first heat dissipation fin group (271) and the second heat dissipation fin group (272), and the partition plate (300) abuts against the bottom side plate (211); and the first heat dissipation fin group (271) is located in the first installation space (110), and the second heat dissipation fin group (272) is located in the second installation space (120).

9. The integrated air source heat pump according to claim 8, **characterized in that**,
the first heat exchanger (710) is an L-shaped fin heat exchanger, the first heat exchanger (710) is connected to the bottom plate (130); the fan bracket (500) extends in a height direction of the first heat exchanger (710); the fan (720) is located in a space enclosed by the L-shaped first heat exchanger (710); and
a side edge of the partition plate (300) proximate to the first heat exchanger (710) is connected to the first heat exchanger (710).

10. The integrated air source heat pump according to claim 9, **characterized in that**,
the fan bracket (500) has a fan bracket vertical portion (510) and a fan bracket lateral portion (520), the fan bracket vertical portion (510) is connected to the first heat exchanger (710), and the fan bracket lateral portion (520) is located above the fan (720); and
the fans (720) is connected to the fan bracket vertical portion (510), the bottom side plate (211) is connected to the fan bracket lateral portion (520), and the slope portion (275) on the first heat dissipation fin group (271) provides a space for the fan bracket lateral portion (520).

11. The integrated air source heat pump according to claim 8, **characterized in that**,
the compressor (740) and the refrigeration system container (770) are connected to the bottom plate (130);
the second heat exchanger (730) is connected to the support plate (400);
the water pump (750) is located above the compressor (740) and the refrigeration system container (770); and
the water pump (750) is fixedly disposed on a water pump bracket (760), an end of the water pump bracket (760) is connected to the partition plate (300), and another end of the water pump bracket (760) is connected to the support plate (400).

12. The integrated air source heat pump according to claim 8, **characterized in that**,
a support beam (600) is disposed in the second installation space (120), an end of the support beam (600) is connected to the partition plate (300), and another end of the support beam (600) is connected to the second heat exchanger (730); and
the debugging board (234) is connected to the support beam (600).

13. The integrated air source heat pump according to claim 8, **characterized in that**,
the partition plate (300) has an L-shaped structure, the partition plate (300) includes a partition plate body (310) and a partition plate flange (320), the partition plate body (310) is connected to the first heat exchanger (710), and the partition plate flange (320) is connected to a front side wall of the housing (100).

## Patentansprüche

1. Wärmepumpe mit integrierter Luftquelle, aufweisend
ein Gehäuse (100), wobei das Gehäuse (100) verwendet wird, um einen Aufnahmeraum (190) zu bilden; und
einen Schaltkasten (200), wobei der Schaltkasten (200) in dem Aufnahmeraum (190) angeordnet ist;
**dadurch gekennzeichnet, dass** der Schaltkasten (200)
einen Hauptkörper des Schaltkastens (200), wobei ein Inneres des Hauptkörpers des Schaltkastens (200) einen Innenraum des Schaltkastens (200) bildet;
eine Halterung (24), wobei die Halterung (24) als Montageträger für Komponenten verwendet wird, und die Halterung (24) in dem Innenraum des Schaltkastens (200) angeordnet ist;
eine Antriebsplatine (231), wobei die Antriebsplatine (231) an der Halterung (24) angeordnet ist, wobei sich die Antriebsplatine (231) an einer Mittelposition des Innenraums des Schaltkastens (200) befindet;
einen Kühler (270), wobei der Kühler (270) verwendet wird, um Wärme von dem Innenraum des Schaltkastens (200) abzuleiten, wobei der Kühler (270) an der Halterung (24) angeordnet ist, und sich der Kühler (270) und die Antriebsplatine (231) jeweils an zwei entgegengesetzten Seiten der Halterung (24) befinden;
mehrere erste Lufteinlassöffnungen (251), wobei die ersten Lufteinlassöffnungen (251) an einer rechten Seite des Hauptkörpers des Schaltkastens (200) angeordnet sind;
mehrere zweite Lufteinlassöffnungen (252), wobei die zweiten Lufteinlassöffnungen (252) an einer Rückseite des Hauptkörpers des Schaltkastens (200) angeordnet sind;
mehrere Luftauslassöffnungen (253), wobei die Luftauslassöffnungen (253) an einer linken Seite des Hauptkörpers des Schaltkastens (200) angeordnet sind;
eine Hauptsteuerplatine (232), wobei die Hauptsteuerplatine (232) an der Halterung (24) angeordnet ist, und sich die Hauptsteuerplatine (232) an einer rechten Position des Innenraums des Schaltkastens (200) befindet;
eine Induktionsspule (233), wobei sich die Induktionsspule (233) an einer linken Position des Innenraums des Schaltkastens (200) befindet;
eine Debugging-Platine (234), wobei die Debugging-Platine (234) an der Hauptsteuerplatine (232) angeordnet ist;
aufweist,
wobei der Hauptkörper des Schaltkastens (200) einen Kastenkörper (210) und eine Kastenabdeckung (220) aufweist, und der Innenraum des Schaltkastens (200) zwischen dem Kastenkörper (210) und der Kastenabdeckung (220) gebildet ist; und
die Kastenabdeckung (220) eine Aufklappplatte (221) aufweist, die abwärts gebogen ist, und zwischen der Aufklappplatte (221) und den Luftauslassöffnungen (253) ein Auslassspalt (254) angeordnet ist.

2. Wärmepumpe mit integrierter Luftquelle nach Anspruch 1, **dadurch gekennzeichnet, dass**
der Kastenkörper (210) eine untere Seitenplatte (211) und eine linke Seitenplatte (212), eine rechte Seitenplatte (213), eine vordere Seitenplatte (215) und eine hintere Seitenplatte (214), die um die untere Seitenplatte (211) herum angeordnet sind, aufweist;
sowohl die Halterung (24) als auch die Induktionsspule (233) an der unteren Seitenplatte (211) angeordnet ist;
an der unteren Seitenplatte (211) eine Öffnung (263) angeordnet ist, und der Kühler (270) von der Öffnung (263) vorsteht; und
die ersten Lufteinlassöffnungen (251) an der rechten Seitenplatte (213) angeordnet sind, die zweiten Lufteinlassöffnungen (252) an der hinteren Seitenplatte (214) angeordnet sind, und die Luftauslassöffnungen (253) an der linken Seitenplatte (212) angeordnet sind.

3. Wärmepumpe mit integrierter Luftquelle nach Anspruch 2, **dadurch gekennzeichnet, dass**
die Halterung (24) eine erste Halterung (241) und eine zweite Halterung (242) aufweist, sich die erste Halterung (241) in einem Mittelbereich des Innenraums des Schaltkastens (200) befindet, und sich die zweite Halterung (242) nahe an der rechten Seitenplatte (213) befindet;
die Antriebsplatine (231) an einer Seite der ersten Halterung (241), die zu der Kastenabdeckung (220) gewandt ist, angeordnet ist, und der Kühler (270) an einer Seite der ersten Halterung (241), die zu der unteren Seitenplatte (211) gewandt ist, angeordnet ist; und
die Hauptsteuerplatine (232) an einer Seite der zweiten Halterung (242), die zu der Kastenabdeckung (220) gewandt ist, angeordnet ist.

4. Wärmepumpe mit integrierter Luftquelle nach Anspruch 3, **dadurch gekennzeichnet, dass**
der Kühler (270) eine erste Wärmeableitungsrippengruppe (271) und eine zweite Wärmeableitungsrippengruppe (272) aufweist, zwischen denen ein Zwischenraum (273) angeordnet ist;
die erste Wärmeableitungsrippengruppe (271) nahe an der linken Seitenplatte (212) liegt, die zweite Wärmeableitungsrippengruppe (272) nahe an der rechten Seitenplatte (213) liegt, an der zweiten Wärmeableitungsrippengruppe (272) wenigstens ein Lüftungsdurchgang (274) zur Lüftung angeordnet ist, und der Lüftungsdurchgang (274) orthogonal zu Rippen der zweiten Wärmeableitungsrippengruppe (272) verläuft;
an einer Seite der ersten Wärmeableitungsrippengruppe (271) nahe an der linken Seitenplatte (212) ein Abschrägungsabschnitt (275) gebildet ist.

5. Wärmepumpe mit integrierter Luftquelle nach Anspruch 4, **dadurch gekennzeichnet, dass**
mehrere Stützabschnitte (243) sowohl an der ersten Halterung (241) als auch der zweiten Halterung (242) angeordnet sind, und die Stützabschnitte (243) verwendet werden, um an der Antriebsplatine (231) und der Hauptsteuerplatine (232) anzuliegen; und
mehrere Klauen (244) sowohl an der ersten Halterung (241) als auch der zweiten Halterung (242) angeordnet sind, und die Klauen (244) zum Einrasten mit der Antriebsplatine (231) und der Hauptsteuerplatine (232) verwendet werden.

6. Wärmepumpe mit integrierter Luftquelle nach Anspruch 4, **dadurch gekennzeichnet, dass**
die hintere Seitenplatte (214) einen ersten hinteren Seitenplattenabschnitt (2141), einen zweiten hinteren Seitenplattenabschnitt (2142) und einen dritten hinteren Seitenplattenabschnitt (2143) aufweist, die der Reihe nach verbunden sind, um eine abgestufte Struktur zu bilden, und ein Abstand zwischen dem ersten hinteren Seitenplattenabschnitt (2141) und der vorderen Seitenplatte (215) größer als ein Abstand zwischen dem dritten hinteren Seitenplattenabschnitt (2143) und dem vorderen Seitenplattenabschnitt (215) ist; und die zweiten Lufteinlassöffnungen (252) an dem ersten hinteren Seitenplattenabschnitt (2141) angeordnet sind.

7. Wärmepumpe mit integrierter Luftquelle nach einem der Ansprüche 4 bis 6, **dadurch gekennzeichnet, dass**
sich der Schaltkasten (200) an einer Oberseite des Aufnahmeraums (190) befindet.

8. Wärmepumpe mit integrierter Luftquelle nach Anspruch 7, **dadurch gekennzeichnet, dass**
das Gehäuse (100) eine untere Platte (130) aufweist, eine Trennplatte (300) und eine Stützplatte (400), die gesondert eingerichtet sind, entlang einer senkrechten Richtung an der unteren Platte (130) angeordnet sind, die Trennplatte (300) den Aufnahmeraum (190) in einen ersten Montageraum (110) und einen zweiten Montageraum (120), die an einer linken Seite und einer rechten Seite angeordnet sind, teilt, und sich die Stützplatte (400) in dem zweiten Montageraum (120) befindet und der Trennplatte (300) direkt gegenüberliegt;
ein erster Wärmeaustauscher (710) in dem ersten Montageraum (110) angeordnet ist, eine Gebläsehalterung (500) an dem ersten Wärmeaustauscher (710) angeordnet ist, und ein Gebläse (720) an der Gebläsehalterung (500) angeordnet ist;
ein Kompressor (740), ein Kühlsystembehälter (770), eine Wasserpumpe (750) und ein zweiter Wärmeaustauscher (730) in dem zweiten Montageraum (120) angeordnet sind; und
der Schaltkasten (200) an Oberseiten des ersten Montageraums (110) und des zweiten Montageraums (120) angeordnet ist, ein linkes Ende des Schaltkastens (200) mit der Gebläsehalterung (500) verbunden ist, und ein rechtes Ende des Schaltkastens (200) mit der Stützplatte (400) verbunden ist; die Trennplatte (300) in den Zwischenraum (273) zwischen der ersten Wärmeableitungsrippengruppe (271) und der zweiten Wärmeableitungsrippengruppe (272) eingesetzt ist, und die Trennplatte (300) an der unteren Seitenplatte (211) anliegt; und sich die erste Wärmeableitungsrippengruppe (271) in dem ersten Montageraum (110) befindet, und sich die zweite Wärmeableitungsrippengruppe (272) in dem zweiten Montageraum (120) befindet.

9. Wärmepumpe mit integrierter Luftquelle nach Anspruch 8, **dadurch gekennzeichnet, dass**
der erste Wärmeaustauscher (710) ein L-förmiger Rippen-Wärmeaustauscher ist, der erste Wärmeaustauscher (710) mit der Bodenplatte (130) verbunden ist; sich die Gebläsehalterung (500) in eine Höhenrichtung des ersten Wärmeaustauschers (710) erstreckt; sich das Gebläse (720) in einem Raum, der von dem L-förmigen ersten Wärmeaustauscher (710) umschlossen ist, befindet; und
eine Seitenkante der Trennplatte (300) nahe an dem ersten Wärmeaustauscher (710) mit dem ersten Wärmeaustauscher (710) verbunden ist.

10. Wärmepumpe mit integrierter Luftquelle nach Anspruch 9, **dadurch gekennzeichnet, dass**
die Gebläsehalterung (500) einen vertikalen Gebläsehalterungsabschnitt (510) und einen lateralen Gebläsehalterungsabschnitt (520) aufweist, der vertikale Gebläsehalterungsabschnitt (510) mit dem ersten Wärmeaustauscher (710) verbunden ist, und sich der laterale Gebläsehalterungabschnitt (520) über dem Gebläse (720) befindet; und
das Gebläse (720) mit dem vertikalen Gebläsehalterungsabschnitt (510) verbunden ist, die untere Seitenplatte (211) mit dem lateralen Gebläsehalterungsabschnitt (520) verbunden ist, und der Abschrägungsabschnitt (275) an der ersten Wärmeableitungsrippengruppe (271) einen Raum für den lateralen Gebläsehalterungsabschnitt (520) bereitstellt.

11. Wärmepumpe mit integrierter Luftquelle nach Anspruch 8, **dadurch gekennzeichnet, dass**
der Kompressor (740) und der Kühlsystembehälter (770) mit der Bodenplatte (130) verbunden sind;
der zweite Wärmeaustauscher (730) mit der Stützplatte (400) verbunden ist;
sich die Wasserpumpe (750) über dem Kompressor (740) und dem Kühlsystembehälter (770) befindet; und
die Wasserpumpe (750) fest an einer Wasserpumpenhalterung (760) angeordnet ist, ein Ende der Wasserpumpenhalterung (760) mit der Trennplatte (300) verbunden ist, und ein anderes Ende der Wasserpumpenhalterung (760) mit der Stützplatte (400) verbunden ist.

12. Wärmepumpe mit integrierter Luftquelle nach Anspruch 8, **dadurch gekennzeichnet, dass**
in dem zweiten Montageraum (120) ein Stützbalken (600) angeordnet ist, ein Ende des Stützbalkens (600) mit der Trennplatte (300) verbunden ist, und ein anders Ende des Stützbalkens (600) mit dem zweiten Wärmeaustauscher (730) verbunden ist; und
die Debugging-Platine (234) mit dem Stützbalken (600) verbunden ist.

13. Wärmepumpe mit integrierter Luftquelle nach Anspruch 8, **dadurch gekennzeichnet, dass**
die Trennplatte (300) einen L-förmigen Aufbau aufweist, die Trennplatte (300) einen Trennplattenkörper (310) und einen Trennplattenflansch (320) aufweist, der Trennplattenkörper (310) mit dem ersten Wärmeaustauscher (710) verbunden ist, und der Trennplattenflansch (320) mit einer frontseitigen Wand des Gehäuses (100) verbunden ist.

## Revendications

1. Pompe à chaleur à source d'air intégrée, comprenant :
un boîtier (100), le boîtier (100) étant utilisé pour former un espace de logement (190) ; et
un coffret électrique (200), le coffret électrique (200) étant disposé dans l'espace de logement (190) ;
**caractérisée en ce que** le coffret électrique (200) comporte :
un corps principal du coffret électrique (200), un intérieur du corps principal du coffret électrique (200) formant un espace intérieur du coffret électrique (200) ;
un support (24), le support (24) étant utilisé comme porteur d'installation de composants, et le support (24) étant disposé dans l'espace intérieur du coffret électrique (200) ;
une carte d'entraînement (231), la carte d'entraînement (231) étant disposée sur le support (24), la carte d'entraînement (231) étant située à une position centrale de l'espace intérieur du coffret électrique (200) ;
un radiateur (270), le radiateur (270) étant utilisé pour dissiper la chaleur de l'espace intérieur du coffret électrique (200), le radiateur (270) étant disposé sur le support (24), et le radiateur (270) et la carte d'entraînement (231) étant disposés respectivement sur deux côtés opposés du support (24) ;
une pluralité de premiers trous d'entrée d'air (251), les premiers trous d'entrée d'air (251) étant disposés sur un côté droit du corps principal du coffret électrique (200) ;
une pluralité de seconds trous d'entrée d'air (252), les seconds trous d'entrée d'air (252) étant disposés sur un côté arrière du corps principal du coffret électrique (200) ;
une pluralité d'orifices de sortie d'air (253), les orifices de sortie d'air (253) étant disposés sur un côté gauche du corps principal du coffret électrique (200) ;
une carte de commande principale (232), la carte de commande principale (232) étant disposée sur le support (24), et la carte de commande principale (232) étant située à une position droite de l'espace intérieur du coffret électrique (200) ;
une bobine d'inductance (233), la bobine d'inductance (233) étant située à une position gauche de l'espace intérieur du coffret électrique (200) ;
une carte de débogage (234), la carte de débogage (234) étant disposée sur la carte de commande principale (232) ;
le corps principal du coffret électrique (200) comporte un corps de coffret (210) et un couvercle de coffret (220), et l'espace intérieur du coffret électrique (200) est formé entre le corps de coffret (210) et le couvercle de coffret (220) ; et
le couvercle de coffret (220) présente une plaque de retournement (221) courbée vers le bas, et un espace de sortie d'air (254) est disposé entre la plaque de retournement (221) et les orifices de sortie d'air (253).

2. Pompe à chaleur à source d'air intégrée selon la revendication 1, **caractérisée en ce que**,
le corps de coffret (210) comporte une plaque de côté inférieur (211), et une plaque de côté gauche (212), une plaque de côté droit (213), une plaque de côté avant (215) et une plaque de côté arrière (214) qui sont disposées autour de la plaque de côté inférieur (211) ;
le support (24) et la bobine d'inductance (233) sont disposés sur la plaque de côté inférieur (211) ;
une ouverture (263) est disposée sur la plaque de côté inférieur (211), et le radiateur (270) dépasse de l'ouverture (263) ; et
les premiers trous d'entrée d'air (251) sont disposés sur la plaque de côté droit (213), les seconds trous d'entrée d'air (252) sont disposés sur la plaque de côté arrière (214), et les trous de sortie d'air (253) sont disposés sur la plaque de côté gauche (212).

3. Pompe à chaleur à source d'air intégrée selon la revendication 2, **caractérisée en ce que**,
le support (24) comporte un premier support (241) et un second support (242), le premier support (241) est situé au milieu de l'espace intérieur du coffret électrique (200), et le second support (242) est à proximité de la plaque de côté droit (213) ;
la carte d'entraînement (231) est disposée sur un côté du premier support (241) faisant face au couvercle de coffret (220), et le radiateur (270) est disposé sur un côté du premier support (241) faisant face à la plaque de côté inférieur (211) ; et
la carte de commande principale (232) est disposée sur un côté du second support (242) faisant face au couvercle de coffret (220).

4. Pompe à chaleur à source d'air intégrée selon la revendication 3, **caractérisée en ce que**,
le radiateur (270) comporte un premier groupe d'ailettes de dissipation de chaleur (271) et un second groupe d'ailettes de dissipation de chaleur (272) avec un espace (273) disposé entre eux ;
le premier groupe d'ailettes de dissipation de chaleur (271) est proche de la plaque de côté gauche (212), le second groupe d'ailettes de dissipation de chaleur (272) est proche de la plaque de côté droit (213), au moins un passage de ventilation (274) pour la ventilation est disposé sur le second groupe d'ailettes de dissipation de chaleur (272), et le passage de ventilation (274) est perpendiculaire à des ailettes du second groupe d'ailettes de dissipation de chaleur (272) ;
une partie inclinée (275) est formée sur un côté du premier groupe d'ailettes de dissipation de chaleur (271) à proximité de la plaque de côté gauche (212).

5. Pompe à chaleur à source d'air intégrée selon la revendication 4, **caractérisée en ce que**,
une pluralité de parties de support (243) sont disposées à la fois sur le premier support (241) et le second support (242) et les parties de support (243) sont utilisées pour venir en butée contre la carte d'entraînement (231) et la carte de commande principale (232) ; et
une pluralité de griffes (244) sont disposées à la fois sur le premier support (241) et le second support (242) et les griffes (244) sont utilisées pour être encliquetées avec la carte d'entraînement (231) et la carte de commande principale (232).

6. Pompe à chaleur à source d'air intégrée selon la revendication 4, **caractérisée en ce que**,
la plaque de côté arrière (214) comporte une première partie de plaque de côté arrière (2141), une deuxième partie de plaque de côté arrière (2142) et une troisième partie de plaque de côté arrière (2143) qui sont connectées séquentiellement pour former une structure étagée, et une distance entre la première partie de plaque de côté arrière (2141) et la plaque de côté avant (215) est supérieure à une distance entre la troisième partie de plaque de côté arrière (2143) et la plaque de côté avant (215) ; et les seconds trous d'entrée d'air (252) sont disposés sur la première partie de plaque de côté arrière (2141).

7. Pompe à chaleur à source d'air intégrée selon l'une quelconque des revendications 4 à 6, **caractérisée en ce que**,
le coffret électrique (200) est situé en haut de l'espace de logement (190).

8. Pompe à chaleur à source d'air intégrée selon la revendication 7, **caractérisée en ce que**,
le boîtier (100) présente une plaque de fond (130), une plaque de séparation (300) et une plaque de support (400) qui sont agencées séparément sont disposées sur la plaque de fond (130) selon une direction verticale, la plaque de séparation (300) divise l'espace de logement (190) en un premier espace d'installation (110) et un second espace d'installation (120) qui sont disposés sur un côté gauche et un côté droit, et la plaque de support (400) est située dans le second espace d'installation (120) et est directement opposée à la plaque de séparation (300) ;
un premier échangeur de chaleur (710) est disposé dans le premier espace d'installation (110), un support de ventilateur (500) est disposé sur le premier échangeur de chaleur (710), et un ventilateur (720) est disposé sur le support de ventilateur (500) ;
un compresseur (740), un conteneur de système de réfrigération (770), une pompe à eau (750) et un second échangeur de chaleur (730) sont disposés dans le second espace d'installation (120) ; et
le coffret électrique (200) est disposé au-dessus du premier espace d'installation (110) et du second espace d'installation (120), une extrémité gauche du coffret électrique (200) est connectée au support de ventilateur (500), et une extrémité droite du coffret électrique (200) est connectée à la plaque de support (400) ; la plaque de séparation (300) est insérée dans l'espace (273) entre le premier groupe d'ailettes de dissipation de chaleur (271) et le second groupe d'ailettes de dissipation de chaleur (272) et la plaque de séparation (300) vient en butée contre la plaque de côté inférieur (211) ; et le premier groupe d'ailettes de dissipation de chaleur (271) est situé dans le premier espace d'installation (110), et le second groupe d'ailettes de dissipation de chaleur (272) est situé dans le second espace d'installation (120).

9. Pompe à chaleur à source d'air intégrée selon la revendication 8, **caractérisée en ce que**,
le premier échangeur de chaleur (710) est un échangeur de chaleur à ailettes en forme de L, le premier échangeur de chaleur (710) est connecté à la plaque inférieure (130) ; le support de ventilateur (500) s'étend dans une direction de hauteur du premier échangeur de chaleur (710) ; le ventilateur (720) est situé dans un espace fermé par le premier échangeur de chaleur en forme de L (710) ; et
un bord latéral de la plaque de séparation (300) proche du premier échangeur de chaleur (710) est connecté au premier échangeur de chaleur (710).

10. Pompe à chaleur à source d'air intégrée selon la revendication 9, **caractérisée en ce que**,
le support de ventilateur (500) présente une partie verticale de support de ventilateur (510) et une partie latérale de support de ventilateur (520), la partie verticale de support de ventilateur (510) est connectée au premier échangeur de chaleur (710), et la partie latérale de support de ventilateur (520) est située au-dessus du ventilateur (720) ; et
les ventilateurs (720) sont connectés à la partie verticale de support de ventilateur (510), la plaque de côté inférieur (211) est connectée à la partie latérale de support de ventilateur (520), et la partie inclinée (275) sur le premier groupe d'ailettes de dissipation de chaleur (271) fournit un espace pour la partie latérale de support de ventilateur (520).

11. Pompe à chaleur à source d'air intégrée selon la revendication 8, **caractérisée en ce que**,
le compresseur (740) et le conteneur de système de réfrigération (770) sont connectés à la plaque inférieure (130) ;
le second échangeur de chaleur (730) est connecté à la plaque de support (400) ;
la pompe à eau (750) est située au-dessus du compresseur (740) et du conteneur de système de réfrigération (770) ; et
la pompe à eau (750) est disposée de manière fixe sur un support de pompe à eau (760), une extrémité du support de pompe à eau (760) est connectée à la plaque de séparation (300), et une autre extrémité du support de pompe à eau (760) est connectée à la plaque de support (400).

12. Pompe à chaleur à source d'air intégrée selon la revendication 8, **caractérisée en ce que**,
une poutre de support (600) est disposée dans le second espace d'installation (120), une extrémité de la poutre de support (600) est connectée à la plaque de séparation (300), et une autre extrémité de la poutre de support (600) est connectée au second échangeur de chaleur (730) ; et
la carte de débogage (234) est connectée à la poutre de support (600).

13. Pompe à chaleur à source d'air intégrée selon la revendication 8, **caractérisée en ce que**,
la plaque de séparation (300) présente une structure en forme de L, la plaque de séparation (300) comporte un corps de plaque de séparation (310) et une bride de plaque de séparation (320), le corps de plaque de séparation (310) est connecté au premier échangeur de chaleur (710), et la bride de plaque de séparation (320) est connectée à une paroi de côté avant du boîtier (100).
